Europäisches Patentamt

(19) European Patent Office                    (11) Publication number: **0 097 157**

Office européen des brevets                                                      **B1**

(12)                              **EUROPEAN PATENT SPECIFICATION**

(45) Date of publication of patent specification: **30.09.87**      (51) Int. Cl.⁴: **H 01 L 23/02,** H 01 L 25/04,
                                                                    **H 01 L 23/12**
(21) Application number: **82900586.7**

(22) Date of filing: **29.12.81**

(86) International application number: .
   **PCT/US81/01754**

(87) International publication number:
   **WO 83/02363 07.07.83 Gazette 83/16**

(54) COOLING MEANS FOR INTEGRATED CIRCUIT CHIP DEVICE.

(43) Date of publication of application:
   **04.01.84 Bulletin 84/01**

(45) Publication of the grant of the patent:
   **30.09.87 Bulletin 87/40**

(84) Designated Contracting States:
   **DE FR GB**

(56) References cited:
   EP-A-0 006 445
   US-A-3 271 638
   US-A-3 449 818
   US-A-3 536 460
   US-A-3 993 123
   US-A-3 996 447
   US-A-4 203 129
   US-A-4 254 431
   US-A-4 323 914

   IBM TECHNICAL DISCLOSURE BULLETIN, vol.
   21, no. 7, December 1978, pages 2819-2820,
   Armonk, New York, US; S. BHATTACHARYA et
   al.: "Chip cooling with thermal impedance
   control"

(73) Proprietor: **International Business Machines
   Corporation**
   **Old Orchard Road**
   **Armonk, N.Y. 10504 (US)**

(72) Inventor: **HASSAN, Javathu K.**
   **55 Wright Boulevard**
   **Hopewell Junction, NY 12533 (US)**
   Inventor: **OKTAY, Sevgin**
   **097 Fox Run**
   **Poughkeepsie, NY 12603 (US)**
   Inventor: **PAIVANAS, John A.**
   **10 Hudson Drive**
   **Hyde Park, NY 12538 (US)**
   Inventor: **SPECTOR, Clarence J.**
   **Fuststrasse 10**
   **D-6501 Niederolm (DE)**

(74) Representative: **Teufel, Fritz IBM Deutschland
   GmbH European Patent Services et al**
   **Box 265**
   **D-8000 München 22 (DE)**

Courier Press, Leamington Spa, England.

**0 097 157**

(56) References cited:

**IBM TECHNICAL DISCLOSURE BULLETIN, vol. 19, no. 9, February 1977, page 3367, Armonk, New York, US; N.G. KOOPMAN et al.: "Solid state expanding alloys for chip thermal connection"**

**IBM TECHNICAL DISCLOSURE BULLETIN, vol. 23, no. 12, May 1981, page 5403, Armonk, New York, US; M.S. MANSURIA et al.: "Conduction cooling structure for a semiconductor package"**

**IBM TECHNICAL DISCLOSURE BULLETIN, vol. 20, no. 7, December 1977, page 2614, Armonk, New York, US; R.N. SPAIGHT: "Thermal enhancement technique for large-scale integrated circuit chip carriers"**

**RÖMPPS Chemie-Lexikon, FRANCKH'sche Verlagshandlung, Stuttgart, page 2405**

## Description

### Technical Field

This invention relates to a cooling means for an integrated circuit chip device, and in particular to a method and means for sustaining low thermal contact resistance to achieve chip cooling.

### Background Art

In the application of integrated circuit (IC) chip devices, it is highly desirable to avoid the imposition of heavy loads on the chip surface, while maintaining intimate contact at the interface between the chip and an adjacent component, such as a heat sink. The intimate contact serves to enhance power dissipation so as to prevent excessive temperature rise and to minimize possible adverse effects, such as dimensional variations, differential thermal expansion, and the like.

For proper power dissipation, it is necessary to draw heat away from the semiconductor chip, and to dissipate the heat in an efficient manner. The heat is generally transferred from one surface of the chip to a heat diffuser or a heat sink, or to a cooling device, for example; and from the opposite surface of the chip to a substrate through a bonding material. The resistance to heat flow through the latter path is relatively much higher. Consequently, the thermal resistance at the interface between the chip surface and the heat diffuser should be minimal in order to maximize heat dissipation.

Generally, prior art heat dissipation techniques of IC chip devices can provide thermal control up to a maximum allowable chip temperature of 85°C without serious problems. However, with the tendency to make semiconductor chips with higher circuit densities, much smaller, and to operate with more power, the magnitude of the heat increases drastically so that presently used cooling techniques alone do not solve the problem of excessive heat. Therefore, it is critical that the thermal resistance at the chip interface be substantially lowered. Furthermore, it is also very important to minimize the thermal resistance at other interfacial locations of the heat sink structure.

However, the mechanical configurations of prior art IC chip assemblies affect the value of the thermal contact resistance that may be attained. For example, what appears to be a smooth continuous bonding of the chip surface and the heat transfer device is in effect a series of relatively few contact points with interposed voids for the most part. Thus, the contact interface provides a relatively high thermal resistance. Ideally, it would be desirable for very small IC chip devices to have a very low contact load at the interface and yet realize a low thermal resistance. Furthermore, these conditions must be controlled and maintained at proper levels for the life of the product.

A device according to the first part of claim 1 is known from "IBM Technical Disclosure Bulletin", Vol. 21, No. 7, December 1978, pages 2819—2820.

### Disclosure of Invention

The technical problems solved by this invention are the efficient dissipation of heat and temperature control in an integrated circuit chip device. A non-eutectic metal alloy is used to form a low thermal resistance bridging interface between the surface of the chip device and a heat sink. The alloy has a solidus-liquidus temperature range such that the solidus is slightly below the maximum operating temperature of the chip, and thus has the capability to re-establish and maintain the interface at a low thermal resistance if stressed during circuit operation, even with a low contact load at the interface of the chip device and the heat sink. In addition to the chip interface, the above cooling means is also used at other interfacial regions of the heat sink, dependent on design, to achieve very low thermal resistance.

### Brief Description of Drawings

FIGS. 1A and 1B are sectional views of an IC circuit semiconductor chip assembly, depicting the condition of the interface between the chip surface and the surface of a heat sink under a contact load, when the chip temperature is respectively less than and greater than the solidus temperature;

FIG. 2 is a sectional view, partially cut away, of one illustrative heat sink technique in an IC chip assembly incorporating the invention at the chip interface;

FIG. 3 is a plot of interface resistance relative to interface temperature, illustrating the thermal resistance reduction and maintenance characteristics at the chip interface with a constant interface contact load; and

FIG. 4 is a sectional view, partially cut away, of another heat sink technique in an IC chip assembly incorporating the invention at both the chip and hat cover interfaces.

### Best Mode for Carrying Out the Invention

With reference to the drawings, an IC package comprises a semiconductor chip 10 that is bonded to a substrate 12 by bonding means 14, which may be solder ball connections, by way of example. A controlled load force F is applied, as designated by the arrow, by means of a spring 16, for example, to the chip 10 to maximize the surface contact of the chip with a pivotable piston heat transfer element 18 of a high thermal conductivity material such as copper. Heat generated in the chip is conducted across the chip interface into the piston element and from the element to the surrounding structure essentially by gaseous conduction across the gap spaces 26. The surrounding hat structure 20 provides a cover and additional heat diffusing means for the IC package.

In accordance with this invention, during assembly of the IC package, a low temperature noneutectic bismuth alloy 22 is bonded to the heat transfer element. In a preferred implementation, the alloy used is commercially available Ostalloy, a product of Arconium Corp. of America.

The alloy is composed of 51.45% bismuth, 31.35% lead, 15.20% tin and 2.0% indium, and is characterized by a solidus temperature $T_S$ of about 88°C, and a liquidus temperature $T_L$ of about 112°C. An alternative low melting temperature alloy that may be used has a composition of 48.35% bismuth, 28.15% lead, 14.50% tin and 9.0% antimony, and has a solidus temperature of about 87°C and liquidus temperature of about 128°C. Still other compositions are also practical depending on desired thermal operating conditions of the IC device.

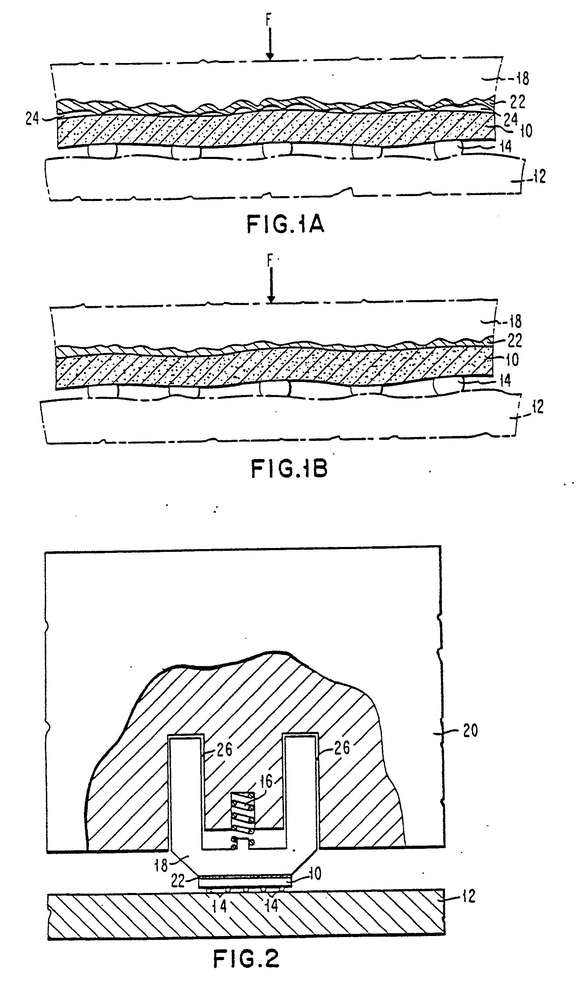

The bismuth alloy 22 is deposited on the heat sink surface to a thickness of approximately 50.8 μm (2 mils), and as illustrated in FIG. 1A, initially only makes actual contact with the surface of the chip 10 at spaced points between voids 24. With this initial condition of the alloy randomly contacting the cold chip surface over a small aggregate heat transfer area, the interface thermal resistance is relatively high, and heat transfer is relatively low.

During the IC package assembly, and after the bismuth alloy has been deposited, the temperature of the device is raised to the melting range of the alloy. As the temperature of the chip is increased to a temperature $T_C$ greater than the solidus temperature $T_S$, the bismuth alloy melts and conforms under viscous flow conditions by the action of the applied force F, to fill the void spaces 24, as depicted in FIG. 1B. The resulting increased contact area and thus the thermal enhanced path between the chip and the heat transfer element through the alloy now filling the voids causes a sharp decrease in thermal resistance at the interface and thus allows effective dissipation of the excessive heat. In this basic process, the above local conforming action of the thin alloy layer is confined to the interface region by the controlling action of surface tension forces.

During continued operation in the field, if disruptions due to dimensional variations, differential thermal expansions and impact load effects, by way of example, occur at the contact interface between the surface of the chip and the heat transfer element, the thermal contact resistance will increase momentarily due to the reoccurrence of voids. As a result, there will be a brief temperature rise excursion into the melting range of the alloy, thereby recovering the low thermal resistance, which is followed by a rapid decrease of temperature to its initial, unperturbed state. In effect, a self-healing process of the alloy melting to conform to the chip surface occurs so that the contact thermal resistance is reduced and further maintained at a low level.

In a preferred implementation, chip interface thermal resistances of 0.1 to 0.2°C per watt are obtained with contact loads of approximately 0.98 N (100 grams). As a comparison, the resistance levels obtained by means of this invention are approximately five to seven times lower than that realized with thermal grease.

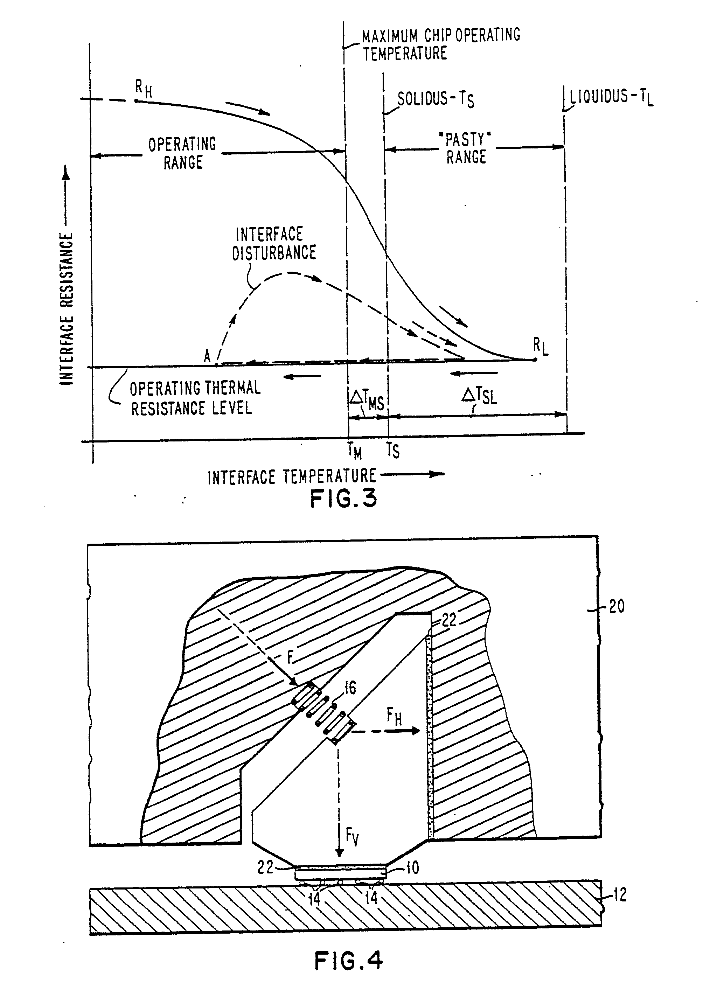

The process according to this invention is illustrated in FIG. 3. The relatively high resistance $R_H$,

at the time of assembly, is reduced to a low level $R_L$ by a reflow operation. Upon reducing the temperature below the maximum operating condition, the resistance remains at such low level $R_L$ in the operating temperature range. However, if an interface disturbance occurs, as illustrated at point A, the rise in resistance causes a temperature rise into the pasty range where the resistance and temperature both decrease rapidly back to their initial states. By way of example, the maximum solidus temperature $\Delta T_{MS}$ would be in the order of 1—3°C, while the solidus-liquidus $\Delta T_{SL}$ may be in the range of 15—25°C.

With this invention, the system is always in a solid state under normal operating conditions. Any excursions into the solidus-liquidus range for thermal resistance-temperature recovery constitutes a very small time period relative to the product life. Since the system is virtually always in the solid state, contact loads at the interface are low and adverse metallurgical phenomena are essentially eliminated. Also, once the initial low resistance value $R_L$ is obtained, any disturbances at the chip surface will cause momentary increases in resistance. These small resistance changes are removed in very short time periods. By means of the self-healing technique disclosed, an extremely low thermal resistance level is maintained without the need for extra reflow steps. The disclosed technique ensures long-term maintenance of low thermal resistance at the chip interface, which is very significant as chip sizes decrease and power dissipation requirements rise.

In addition to achieving low thermal resistance at the chip interface, as by application of the illustrated heat sink technique in FIG. 2, this invention can also be applied to other interfaces in a heat sink structure to obtain low thermal resistance. An example of such a structure, where this invention is used at both the chip and hat interfaces, is illustrated in FIG. 4. A controlled load force F is applied diagonally, as designated by the arrow, by means of a spring 16, for example, to a pivotable piston heat transfer element 18. By this arrangement, the surface contacts of the heat transfer element 18 with the chip surface 10 and hat surface 20 are maximized and acted on by load force components $F_V$ and $F_H$, respectively. The bismuth alloy 22 is deposited on each surface of the piston to a thickness of approximately 50.8 μm (2 mils), and as illustrated in FIG. 1A, initially only makes actual contact with the surface of the chip 10 at spaced points between the voids 24. Similarly, the contact of the alloy 22 with the hat 20 surface also involves point contacts and void spaces. With this initial condition of the alloy randomly contacting the cold chip and hat surfaces over a small aggregate heat transfer area, the thermal resistance at the interfaces is relatively high, and heat transfer is relatively low.

During the IC package assembly, and after the bismuth alloy has been deposited, the temperature of the device is raised to the melting range of the alloy. As the temperature of the chip is increased to a temperature $T_c$ greater than the solidus temperature $T_s$, the bismuth alloy melts and under the action of the applied force component $F_V$, fills the void spaces as described previously. Essentially at the same time, due to the high thermal conductivity of the intervening piston material, the alloy melts at the hat interface, and under the action of the applied force component $F_H$, fills the void spaces in this region. The resulting increased contact area at both interfaces causes a sharp decrease in thermal resistances and thus allows effective dissipation of the excessive heat.

During continued operation in the field, if disruptions to the interfaces occur, for reasons as discussed previously in connection with the chip contact, the thermal contact resistances will increase momentarily due to the reoccurrence of voids at the chip and hat interfaces. As a result, there will be brief temperature rise excursions into the melting range of the alloy, thereby recovering the low thermal resistances followed by a rapid decrease of temperatures to initial, unperturbed states. In effect, a self-healing process of the alloy melting to conform to the chip and hat surfaces occurs so that the contact thermal resistances are reduced and further maintained at low levels.

The process according to this invention is illustrated in FIG. 3 for the case of the chip contact surface condition. The process for the hat interface condition is the same as that for the chip contact. Thus, in both interface conditions the relatively high resistances $R_H$, at the time of assembly, are reduced to low levels $R_L$ by a reflow operation. Upon reducing the temperature below the maximum operating condition, the resistances remain at such low levels $R_L$ in the operating temperature range. If disturbance of the interfaces occurs, the self-healing action of the alloy causes a rapid recovery of the low thermal resistances and temperatures in a manner discussed previously in connection with FIG. 3.

As discussed above, in a preferred implementation the chip interface thermal resistances of 0.1 to 0.2°C per watt are obtained with contact loads of approximately 0.98 N (100 grams). For the relatively much larger contact area of the bismuth alloy with the hat surface and with this magnitude of contact loads, the corresponding preferred hat interface thermal resistances are in the range of 0.01 to 0.02°C per watt.

The IC chip cooling techniques illustrated in FIGS. 2 and 4 represent just two of a number of possible configurations for achieving and maintaining highly effective heat dissipation. With the structure of this invention, applications that require from 9—20 watts/chip heat dissipation are feasible.

## Claims

1. Cooling assembly for semiconductor chips (10) on a substrate (12) comprising heat transfer elements (18) that contact the back side of the chips with a surface covered by a heat-conducting layer (22) of an alloy whose melting point is above the normal operation temperature of the chips, characterized in that the alloy is non-eutectic and has a solidus temperature near the normal operating temperature of the chips and a liquidus temperature which is sufficiently above the solidus temperature to prevent complete melting of the layer during a transient temperature increase of the chip after an increase of the thermal resistance between the chip and the heat transfer element.

2. The assembly of claim 1, wherein said non-eutectic alloy is formed with bismuth.

3. The assembly of claim 2, wherein said alloy is made of 51.45% bismuth; 31.35% lead; 15.20% tin and 2.0% indium by weight, the solidus temperature being 88°C, the liquidus temperature 112°C.

4. The assembly of claim 2, wherein said alloy is made of 48.35% bismuth; 28.15% lead; 14.50% tin and 9.0% antimony by weight, the solidus temperature being 87°C, the liquidus temperature 128°C.

5. The assembly of one of the claims 1—4, wherein the thickness of said alloy layer is about 50.8 μm (2 mils).

6. The assembly of one of the claims 1—5, wherein the chip interface thermal resistance is in the range of 0.1—0.2°C per watt for a contact load of 0.98 N (100 grams).

7. The assembly of one of the claims 1—6, including a second heat conducting layer of alloy between the heat transfer element and a mounting hat (20) for the heat transfer elements.

8. A semiconductor assembly as in claim 7, wherein the hat interface thermal resistance is in the range of 0.01—0.02°C per watt for a contact load of 0.98 N (100 grams).

## Patentansprüche

1. Kühlvorrichtung für Halbleiterplättchen (10) auf einem Substrat (12) mit Wärmeübertragungselementen (18), welche die Rückseite der Plättchen mit einer Oberfläche kontaktieren, die mit einer wärmeleitenden Schicht (22) einer Legierung bedeckt ist, deren Schmelzpunkt sich über der normalen Betriebstemperatur der Plättchen befindet, dadurch gekennzeichnet, daß die Legierung nicht eutektisch ist und eine Solidus-Temperatur nahe der normalen Betriebstemperatur der Plättchen hat, und eine Liquidus-Temperatur, die ausreichend über der Solidus-Temperatur liegt, um ein völliges Schmelzen der Schicht während einem Anstieg der Übergangstemperatur des Plättchens nach einer Vergrößerung des thermischen Widerstandes zwischen dem Plättchen und dem Wärmeübertragungselement zu verhindern.

2. Anordnung nach Anspruch 1, worin die nicht eutektische Legierung mit Wismut gebildet wird.

3. Anordnung nach Anspruch 2, worin die Legierung aus 52,45 Gew. % Wismut, 31,35 Gew. % Blei, 15,20 Gew. % Zinn und 2,0 Gew. %

Indium besteht, die Solidus-Temperatur 88°C und die Liquidus-Temperatur 112°C beträgt.

4. Anordnung nach Anspruch 2, worin die Legierung aus 45,35 Gew. % Wismut, 28,15 Gew. % Blei, 14,50 Gew. % Zinn und 9,0 Gew. % Antimonium besteht, die Solidus-Temperatur 87°C und die Liquidus-Temperatur 128°C beträgt.

5. Anordnung nach einem der Ansprüche 1 bis 4, worin die Dicke der Legierungsschicht ungefähr 50,8 µm (2 mils) beträgt.

6. Anordnung nach einem der Ansprüche 1 bis 5, worin der thermische Schnittstellenwiderstand des Plättchen sich in der Größenordnung von 0,1 bis 0,2°C pro Watt für eine Kontaktbelastung 0,98 N (100 gr) bewegt.

7. Anordnung nach einem der Ansprüche 1 bis 6, mit einer zweiten wärmeleitenden Legierungsschicht zwischen dem Wärmeübertragungselement und einer Abdeckung (20) für die Wärmeübertragungselemente.

8. Halbleiteranordnung nach Anspruch 7, worin sich der thermische Schnittstellenwiderstand der Abdeckung in der Größenordnung von 0,01 bis 0,02°C pro Watt für eine Kontaktbelastung von 0,98 N (100 gr) bewegt.

**Revendications**

1. Dispositif de refroidissement pour des microplaquettes à semiconducteurs (10) situées sur un substrat (12), comportant des éléments de transfert thermique (18), qui sont en contact avec la face arrière des microplaquettes, au niveau d'une surface recouverte par une couche thermoconductrice (22) d'un alliage, dont le point de fusion est supérieur à la température de fonctionnement normal des microplaquettes, caractérisé en ce que l'alliage est non eutectique et possède une température de solidus proche de la température normale de fonctionnement des microplaquettes et une température de liquidus qui est suffisamment supérieure à la température de solidus pour empêcher une fusion complète de la couche pendant un accroissement temporaire de la température de la microplaquette après un accroissement de la résistance thermique entre la microplaquette et l'élément de transfert thermique.

2. Dispositif selon la revendication 1, dans lequel ledit alliage non eutectique est formé avec du bismuth.

3. Dispositif selon la revendication 2, dans lequel ledit alliage est constitué par 51,45 % de bismuth; 31,35 % de plomb; 15,20 % d'étain et 2,0 d'indium en poids, la température de solidus étant égale à 88°C et la température de liquidus à 112°C.

4. Dispositif selon la revendication 2, dans lequel ledit alliage est formé par 48,35 % de bismuth; 28,15 % de plomb; 14,50 % d'étain et 9,0 % d'antimoine en poids, la température de solidus étant égale à 87°C et la température de liquidus à 128°C.

5. Dispositif selon l'une des revendications 1—4, dans lequel l'épaisseur de ladite couche d'alliage est égale à environ 50,8 µm (2 millièmes de pouce).

6. Dispositif selon l'une des revendications 1—5, dans lequel la résistance thermique de l'interface de la microplaquette se situe dans la gamme de 0,1—0,2°C par watt pour une charge de contact de 0,98 N (100 grammes).

7. Dispositif selon l'une des revendications 1—6, contenant une seconde couche thermoconductrice d'alliage située entre l'élément de transfert thermique et un chapeau (20) de montage pour les éléments de transfert thermique.

8. Dispositif à semiconducteurs selon la revendication 7, dans lequel la résistance thermique de l'interface du chapeau se situe dans la gamme de 0,01—0,02°C par watt pour une charge de contact de 0,98 N (100 grammes).

FIG.1A

FIG.1B

FIG.2

FIG.3

FIG.4